# EUROPEAN PATENT APPLICATION

(11) **EP 4 718 222 A1**
(43) Date of publication of application: **01.04.2026**
(21) Application number: 25198690.7
(22) Date of filing: 28.08.2025
(51) Int. Cl.: G06F 3/041, H10K 59/40, H10K 59/80

(54) **DISPLAY APPARATUS AND METHOD OF MANUFACTURING THE SAME**

(30) Priority: 30.09.2024 KR 20240133127
(71) Applicant: LG Display Co., Ltd., Seoul 150-721 (KR)
(72) Inventor: KIM, Young Hun, Paju-si, Gyeonggi-do (KR); UM, Hyun Soo, Paju-si, Gyeonggi-do (KR); KIM, Dae Yun, Paju-si, Gyeonggi-do (KR)
(74) Representative: Viering, Jentschura & Partner mbB Patent- und Rechtsanwälte

(57) **Abstract**

Disclosed are a display apparatus and a method of manufacturing the same. A display apparatus according to an embodiment including a display panel (100) having an active area and a non-active area, a cover member (140) disposed on the display panel (100), a touch sensor layer (130) disposed between the display panel (100) and the cover member (140), and a transparent adhesive member (120) disposed between the display panel (100) and the touch sensor layer (130), wherein the transparent adhesive member (120) includes a plastic film (122) having a plurality of concave portions (124) provided at a rear surface of a corner portion thereof, an upper transparent adhesive member (121) disposed on an upper surface of the plastic film (122), and a lower transparent adhesive member (123) disposed on a lower surface of the plastic film (122).

## Description

### BACKGROUND OF THE INVENTION

### Field of the Invention

The present disclosure relates to a display apparatus, and more particularly to a display apparatus and a method of manufacturing the same capable of eliminating defects that occur during a bonding process of the display apparatus.

### Discussion of the Related Art

An image display apparatus that provides various kinds of information on a screen is core technology in the information and communication era, and is developing in the direction of being thinner, lighter, more portable, and higher-performance. As a result, a display apparatus that may be manufactured in a lightweight and thin form is in the spotlight.

Specific examples of the display apparatus include a liquid crystal display apparatus (LCD), a quantum dot display apparatus (QD), a field emission display apparatus (FED), and an organic light emitting display apparatus (OLED).

The organic light emitting display apparatus is a self-luminous display apparatus, which is not only advantageous in terms of power consumption due to low voltage operation, but also have excellent color expression, response time, viewing angle, and contrast ratio (CR), and is being studied as a display apparatus.

Generally, the organic light emitting display apparatus has a structure in which a back plate, an organic light emitting display panel, a polarizer, a touch sensor, and a cover member are stacked, and each of components is bonded by an adhesive member. For example, the polarizer and the touch sensor are bonded together by an adhesive member disposed therebetween.

However, as the shape of the display panel and the touch sensor become more diverse, the contact surfaces of the touch sensor and the adhesive member may be bent, and bubbles may occur between the touch sensor and the adhesive member at a corner area of the display apparatus.

**In** addition, the adhesive member may protrude outward due to the force applied during bonding process.

### SUMMARY OF THE INVENTION

Accordingly, the present disclosure is directed to a display apparatus and a method for manufacturing the same that substantially obviate one or more problems due to limitations and disadvantages of the related art.

It is an object of the present disclosure to provide a display apparatus and a method for manufacturing the same capable of eliminating defects that occur during a bonding process.

Objects of the present disclosure devised to solve the problems are not limited to the aforementioned object, and other unmentioned objects will be clearly understood by those skilled in the art based on the following detailed description of the present disclosure. Various embodiments of the present disclosure provide a display apparatus and method of manufacturing a display apparatus according to the independent claims. Further embodiments are described in the dependent claims.

A display apparatus according to an embodiment of the present disclosure includes a display panel having an active area and a non-active area, a cover member disposed on the display panel, a touch sensor layer disposed between the display panel and the cover member, and a transparent adhesive member disposed between the display panel and the touch sensor layer, wherein the transparent adhesive member includes a plastic film having a plurality of concave portions provided at a rear surface of a corner portion thereof, an upper transparent adhesive member disposed on an upper surface of the plastic film, and a lower transparent adhesive member disposed on a lower surface of the plastic film.

A method for manufacturing a display apparatus according to an embodiment of the present disclosure includes preparing a transparent adhesive member including a plastic film having a plurality of concave portions provided at a rear surface of a corner portion thereof, an upper transparent adhesive member disposed on an upper surface of the plastic film, the upper transparent adhesive member being provided at an upper surface of a corner portion thereof with a plurality of passages configured to allow bubbles to be discharged to the outside therethrough, and a lower transparent adhesive member disposed on a lower surface of the plastic film, preparing a cover member and a touch sensor layer disposed under the cover member, bonding the upper transparent adhesive member of the transparent adhesive member to a lower surface of the touch sensor layer, and bonding a display panel having an active area and a non-active area to the lower transparent adhesive member of the transparent adhesive member.

Specific details of other embodiments are included in the detailed description and the drawings.

### BRIEF DESCRIPTION OF THE DRAWINGS

The accompanying drawings, which are included to provide a further understanding of the present disclosure and are incorporated in and constitute a part of this application, illustrate embodiment(s) of the present disclosure and together with the description serve to explain the principle of the present disclosure. In the drawings:
FIG. 1 is a block diagram showing a display apparatus according to an embodiment of the present disclosure;
FIG. 2 is a circuit diagram showing a pixel circuit in the display apparatus according to the embodiment of the present disclosure;
FIG. 3 is a sectional view showing the display apparatus according to the embodiment of the present disclosure;
FIG. 4 is a sectional view of a transparent adhesive member according to an embodiment of the present disclosure;
FIG. 5 is a plan view of an upper transparent adhesive member of the transparent adhesive member according to the embodiment of the present disclosure;
FIG. 6 is a rear view of a plastic film of the transparent adhesive member according to the embodiment of the present disclosure; and
FIGs. 7A to 7D are process sectional views illustrating a method of manufacturing a display apparatus according to an embodiment of the present disclosure.

### DETAILED DESCRIPTION OF THE INVENTION

Hereinafter, preferred embodiments of the present disclosure will be described with reference to the accompanying drawings. Throughout the specification, the same reference numerals designate substantially the same components.

In the following description, a detailed description of known technologies and configurations incorporated herein will be omitted when it may make the subject matter of the present disclosure rather unclear. In addition, names of components used in the following description are selected in consideration of ease in preparing the specification, and may be different from names of parts of an actual product.

In the drawings for explaining various embodiments of the present disclosure, for example, the illustrated shape, size, ratio, angle, and number are given by way of example, and thus, are not limitative of the present disclosure. Throughout the specification, the same reference numerals designate the same components.

Also, in describing the specification, a detailed description of known technologies will be omitted when it may make the subject matter of the present disclosure rather unclear.

The terms "comprises", "includes", and/or "has", used in this specification, do not preclude the presence or addition of other elements unless used along with the term "only". The singular forms are intended to include the plural forms as well, unless the context clearly indicates otherwise.

In the interpretation of components included in various embodiments of the present disclosure, the components are interpreted as including an error range even if there is no explicit description thereof.

In describing positional relationships in various embodiments of the present disclosure, for example, when the positional relationship between two parts is described using "on", "above", "below", "beside", or the like, one or more other parts may be located between the two parts unless the term "directly" or "closely" is used therewith

In describing temporal relationships in various embodiments of the present disclosure, for example, when the temporal relationship between two actions is described using "after", "subsequently", "next", "before", or the like, the actions may not occur in succession unless the term "immediately" or "directly" is used therewith.

In describing various embodiments of the present disclosure, although terms such as, for example, "first" and "second" may be used to describe various components, these terms are merely used to distinguish the same or similar components from each other. Therefore, in the specification, a component modified by "first" may be the same as a component modified by "second" within the technical scope of the present disclosure unless mentioned otherwise.

The respective features of various embodiments of the present disclosure may be partially or wholly coupled to and combined with each other, and various technical linkages therebetween and operation methods thereof are possible. The various embodiments may be performed independently of each other, or may be performed in association with each other.

Hereinafter, a display apparatus according to an embodiment of the present disclosure will be described with reference to the drawings.

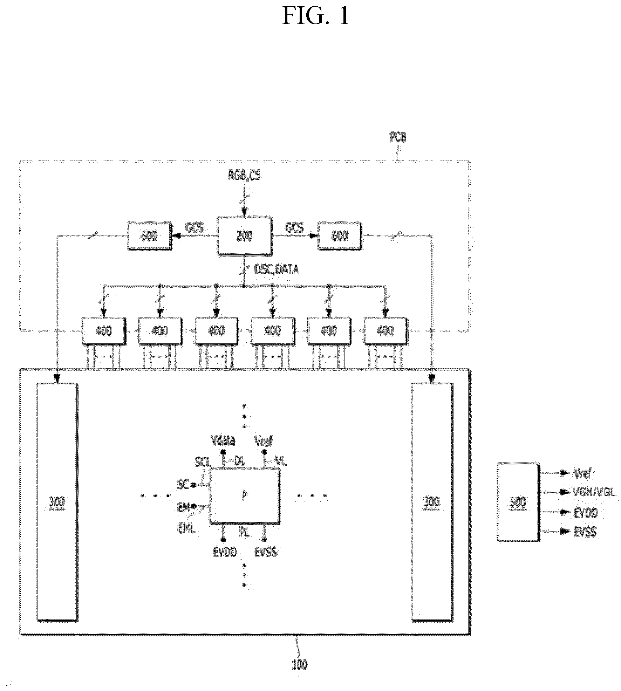

FIG. 1 is a schematic sectional view of a display apparatus according to an embodiment of the present disclosure.

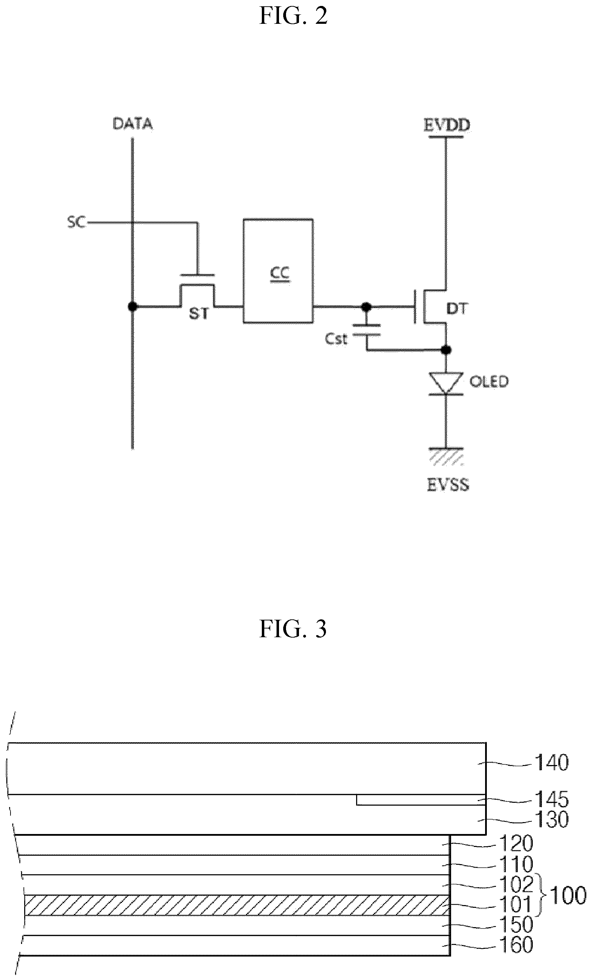

FIG. 2 is a circuit diagram of a subpixel included in the display apparatus according to the embodiment of the present disclosure.

As shown in FIG. 1, the display apparatus according to the embodiment of the present disclosure includes a display panel 100 including a plurality of pixels P, a controller 200, a gate drive circuit 300 configured to supply a gate signal to each of the plurality of pixels P, a data drive circuit 400 configured to supply a data signal to each of the plurality of pixels P, a power supply unit 500 configured to supply power for operation to each of the plurality of pixels P, a level shifter 600 configured to adjust the potential of the gate signal applied to the gate drive circuit 300, and a sensing unit (not shown) configured to sense deterioration of the plurality of pixels P. Here, the controller 200, the gate drive circuit 300, the data drive circuit 400, and the sensing unit may be collectively referred to as a control unit.

The display panel 100 may include an active area AA in which the pixels P are located and a non-active area NA in which a gate drive circuit 300 and a data drive circuit 400 are disposed, the non-active area being disposed so as to surround the active area AA. The gate drive circuit 300 may be disposed in the active area AA.

In the display panel 100, a plurality of gate lines SCL and EML and a plurality of data lines DL intersect each other, each of the plurality of pixels P is connected to a corresponding one of the gate lines SCL and EML and a corresponding one of the data lines DL. Specifically, one pixel P receives a gate signal from the gate drive circuit 300 via the gate line SCL and EML, receives a data signal from the data drive circuit 400 via the data line DL, and receives a high-potential drive voltage EVDD and a low-potential drive voltage EVSS from the power supply unit 500 via a drive voltage line PL.

Here, the gate lines SCL and EML supply scan signals SC and emission control signals EM, and the data lines DL supply data voltages Vdata. In addition, according to various embodiments, the gate lines SCL and EML may include a plurality of scan lines SCL configured to supply scan signals SC and a plurality of emission control lines EML configured to supply emission control signals EM. In addition, each of the plurality of pixels P may further include a power line VL to receive a reference voltage Vref and an initialization voltage Vini.

Each thin-film transistor (TFT) constituting the pixel P may be implemented as an oxide TFT including an oxide semiconductor layer. The oxide TFT may be advantageous for large-area display panels 100 in consideration of electron mobility, process deviation, etc. The present disclosure is not limited thereto, and the semiconductor layer of the TFT may be made of amorphous silicon or polysilicon.

In addition, each pixel P includes a light emitting diode and a pixel circuit configured to control the operation of the light emitting diode. Here, the light emitting diode may include an anode, a cathode, and an emission layer disposed between the anode and the cathode.

As shown in FIG. 2, each pixel P may include a switching transistor ST, a drive transistor DT, a compensation circuit CC, a light emitting diode OLED, and a storage capacitor Cst.

The light emitting diode OLED may be operated to emit light according to a drive current formed by the drive transistor DT.

The switching transistor ST may be switched such that a data signal DATA supplied through the data line DL is stored in the storage capacitor Cst as a data voltage in response to the scan signal SC supplied through the scan line SCL. The storage capacitor Cst may maintain the data voltage for one frame.

The drive transistor DT may operate such that a constant drive current flows between the high-potential power line EVDD and the low-potential power line EVSS in response to the data voltage stored in the storage capacitor Cst.

The compensation circuit CC is a circuit configured to compensate for the threshold voltage of the drive transistor DT, and the compensation circuit CC may include one or more thin-film transistors and a capacitor. The configuration of the compensation circuit CC may vary greatly depending on a compensation method.

For example, the pixel P shown in FIG. 2 has a 2T (Transistor) 1C (Capacitor) structure including a switching transistor ST, a drive transistor DT, a storage capacitor Cst, and a light emitting diode OLED, but if the compensation circuit CC is added, the pixel may have various structures, such as 3T1C, 4T2C, 5T2C, 6T1C, 6T2C, 7T1C, 7T2C, and 8T1C structures.

The display panel 100 may be implemented as a non-transmissive display panel or a transmissive display panel. The transmissive display panel may be applied to a transparent display apparatus in which an image is displayed on the screen and a real object in the background is visible. The display panel 100 may be manufactured as a flexible display panel. The flexible display panel may be implemented as an organic light emitting display panel using a plastic substrate.

Each pixel P may be divided into a red pixel, a green pixel, and a blue pixel for color realization. Each pixel P may further include a white pixel. Each pixel P includes a pixel circuit.

Touch sensors may be disposed on the display panel 100. Touch input may be sensed using separate touch sensors or through the pixels P. The touch sensors may be implemented as on-cell or add-on type touch sensors that are disposed on the display panel or as in-cell type touch sensors that are embedded in the display panel 100.

The controller 200 processes image data RGB input from the outside so as to correspond to the size and resolution of the display panel 100 and supplies the same to the data drive circuit 400. The controller 200 generates a gate control signal GCS and a data control signal DCS using timing signals CS input from the outside, such as a dot clock signal CLK, a data enable signal DE, a horizontal synchronization signal Hsync, and a vertical synchronization signal Vsync. The generated gate control signal GCS and data control signal DCS are supplied to the gate drive circuit 300 and the data drive circuit 400, respectively, to control the gate drive circuit 300 and the data drive circuit 400.

The controller 200 may be coupled to various processors, such as a microprocessor, a mobile processor, an application processor, depending on a device in which the controller is mounted.

A host system may be any one of a television (TV) system, a set-top box, a navigation system, a personal computer (PC), a home theater system, a mobile device, a wearable device, and a vehicle system.

The controller 200 may control the operation timing of the display panel drive unit using a frame frequency of the input frame frequency × i (where i is a positive integer greater than 0) Hz obtained by multiplying the input frame frequency by i times. The input frame frequency is 60 Hz in a national television standards committee (NTSC) method and 50 Hz in a phase-alternating line (PAL) method.

The controller 200 generates a signal to enable the pixel P to be driven at various refresh rates. That is, the controller 200 generates signals associated with driving such that the pixel P may be driven in a variable refresh rate (VRR) mode or to switch between a first refresh rate and a second refresh rate. For example, the controller 200 may drive the pixel P at various refresh rates by simply changing the speed of a clock signal, generating a synchronizing signal to create a horizontal blank or a vertical blank, or driving the gate drive circuit 300 in a mask manner.

Based on the timing signal CS received from the host system, the controller 200 generates a gate control signal GCS for controlling the operation timing of the gate drive circuit 300 and a data control signal DSC for controlling the operation timing of the data drive circuit 400. The controller 200 controls the operation timing of the display panel drive unit to synchronize the gate drive circuit 300 and the data drive circuit 400.

The data drive circuit 400 receives the image data DATA and the data control signal DCS from the controller 200. The data drive circuit 400 converts the image data DATA into a gamma-compensated voltage to generate a data voltage Vdata in response to the data control signal DCS from the controller 200, and supplies the data voltage Vdata to the data lines DL of the display panel 100 in synchronization with the scan signal SC. The data drive circuit 400 may be connected to the data lines of the display panel 100 through a chip on glass (COG) or tape automated bonding (TAB) process.

The gate drive circuit 300 is operated according to the gate control signal GCS input from the level shifter 600 to generate a gate signal, and sequentially supplies the gate signal to gate lines GL. The gate drive circuit 300 may be formed directly on a lower substrate of the display panel 100 using a gate driver in panel (GIP) method. The gate drive circuit 300 may be formed in the active area AA of the display panel 100 in which the screen is displayed, or may be formed in the non-active area NA outside the active area AA. The non-active area NA may include a bezel area, or may be the same as the bezel area. In the GIP method, the level shifter 600 may be mounted on a printed circuit board (PCB) together with the controller 200.

The power supply unit 500 generates DC power required to drive a pixel array of the display panel 100 and a display panel driver using a DC-DC converter. The DC-DC converter may include a charge pump, a regulator, a buck converter, and a boost converter. The power supply unit 500 receives a DC input voltage from the host system (not shown) to generate DC voltages such as gate-on voltages VGL and VEL, gate-off voltages VGH and VEH, a high-potential drive voltage EVDD, and a low-potential drive voltage EVSS. The gate-on voltages VGL and VEL and the gate-off voltages VGH and VEH are supplied to the level shifter and the gate drive circuit 300. The high-potential drive voltage EVDD and the low-potential drive voltage EVSS are supplied to the pixels P in common.

The level shifter 600 boosts a transistor-transistor-logic (TTL) level voltage of the gate control signal GCS input from the controller 200 to a gate high voltage VGH and a gate low voltage VGL that can drive the TFT formed on the display panel 100 and supplies the same to the gate drive circuit 300. The gate control signal GCS may include a start signal and a clock signal. The plurality of pixels P of the display panel 100 may include at least a first pixel, a second pixel, and a third pixel. The first pixel, the second pixel, and the third pixel may emit light of different colors. For example, the first pixel may be a red pixel, the second pixel may be a green pixel, and the third pixel may be a blue pixel.

The plurality of pixels P may have the same size or different sizes. The first, second, and third pixels may be designed so as to have different sizes taking into account the lifetime of the light emitting diode OLED included in each of the first, second, and third pixels or the color balance.

FIG. 3 is a sectional view showing the display apparatus according to the embodiment of the present disclosure.

As shown in FIG. 3, in the display apparatus, an array layer 102 including a thin-film transistor, a light emitting diode, and an encapsulation unit may be disposed on a substrate 101, and a polarizing layer 110 may be disposed on the array layer 102. A display panel 100 may be constituted by the substrate 101 and the array layer 102 disposed thereon.

A back plate 150 may be disposed under the substrate 101, and a metal plate 160 may be disposed under the back plate 150.

Meanwhile, a black matrix 145 may be disposed on a lower surface of a cover glass 140 in the non-active area, and a touch sensor layer 130 may be disposed under the cover glass 140.

The cover glass 140 having the touch sensor layer 130 and the substrate 101 having the array layer 102, the polarizing layer 110, the back plate 150, and the metal plate 160 are bonded by a transparent adhesive member (OCA) 120. That is, the touch sensor layer 130 and the polarizing layer 110 are bonded together by the transparent adhesive member 120.

When the touch sensor layer 130 and the polarizing layer 110 are bonded by the transparent adhesive member 120, bubbles may occur due to non-bonding between the touch sensor layer 130 and the polarizing layer 110 at a corner of the display apparatus due to bending of the touch sensor layer 130. In addition, due to fluidity of the transparent adhesive member 120, the transparent adhesive member may protrude to the outside due to the force applied during bonding process.

In the present disclosure, the transparent adhesive member 120 may be provided to prevent the occurrence of bubbles between the touch sensor layer 130 and the transparent adhesive member 120 in the corner area of the display apparatus and to prevent the transparent adhesive member 120 from protruding to the outside.

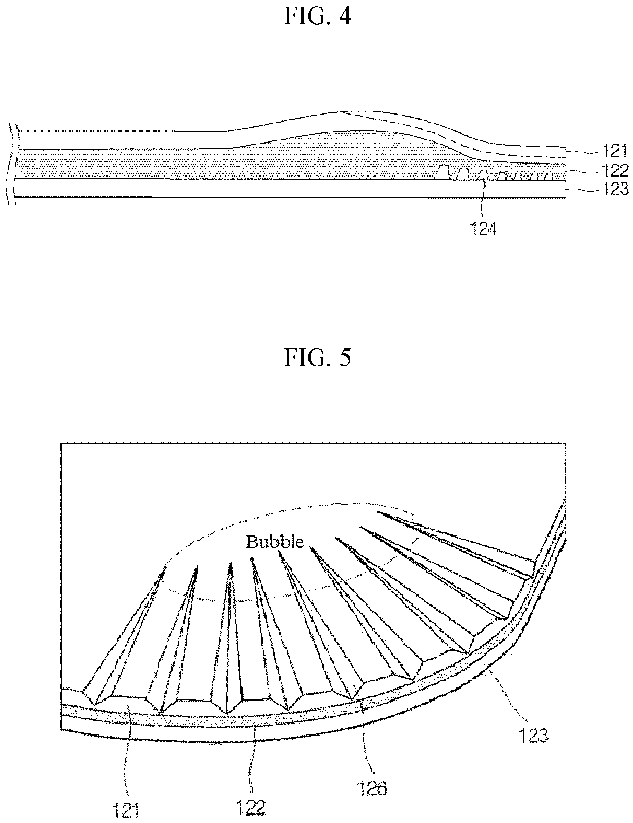

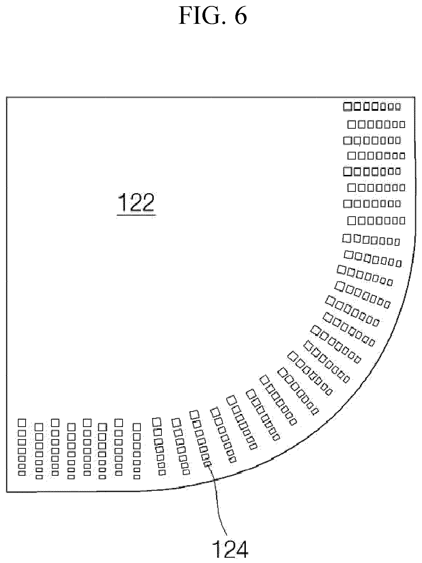

FIG. 4 is a sectional view of a transparent adhesive member 120 according to an embodiment of the present disclosure, FIG. 5 is a plan view of an upper transparent adhesive member 121 of the transparent adhesive member 120 according to the embodiment of the present disclosure, and FIG. 6 is a rear view of a plastic film of the transparent adhesive member 120 according to the embodiment of the present disclosure.

As shown in FIG. 4, the transparent adhesive member 120 according to the embodiment of the present disclosure may include an upper transparent adhesive member 121, a plastic film 122, and a lower transparent adhesive member 123. For example, the upper transparent adhesive member 121 may be disposed on an upper surface of the plastic film 122, and the lower transparent adhesive member 123 may be disposed on a lower surface of the plastic film 122.

The plastic film 122 may be formed so as to have a thickness that can compensate for bending (step) of the touch sensor layer 130 in consideration of bending of the touch sensor layer 130. That is, the plastic film 122 may have a convex portion corresponding to a concave portion of the touch sensor layer 130. The plastic film 122 may improve the corner flatness of the display apparatus.

In order to prevent the transparent adhesive member 120 from protruding to the outside, a rear surface of a corner portion of the plastic film 122 may be provided with a plurality of concave portions 124 each having a trapezoidal structure at the corner portion, as shown in FIG. 6. The plurality of concave portions 124 may be disposed in the non-active area, and each may have a depth and width gradually decreasing in a direction toward the edge. That is to say, as shown in Figure 4, among the plurality of concave portions 124, the depth and width of the concave portions 124 closer to the edge of the transparent adhesive member 120 are smaller than those of the concave portions 124 farther from the edge of the transparent adhesive member 120.

Each concave portion 124 may be formed in a trapezoidal structure having a structure perpendicular to the rear surface of the plastic film 122 in a direction toward the edge of the transparent adhesive member 120 and an acute-angled structure with respect to the rear surface of the plastic film 12 in the opposite direction.

In FIG.4, the structure of each concave portion 124 is shown as a trapezoidal structure; however, the present disclosure is not limited thereto, and the concave portion may be formed in various shapes such as a semicircular shape, a triangular shape, a quadrangular shape, and a pentagonal shape.

Meanwhile, in order to prevent the occurrence of bubbles due to non-bonding at the corner of the display apparatus, a plurality of passages 126, through which the bubbles may be discharged to the outside, may be formed on an upper surface of a corner portion of the upper transparent adhesive member 121, as shown in FIG. 5. The plurality of passages 126 may be disposed in a fan-shaped manner.

Each passage 126 may extend in the direction from the area where bubbles are expected to occur to the edge of the corner portion, and the width of each passage 126 may gradually increase in the direction from the area where bubbles are expected to occur to the edge of the corner portion. That is, as the volume of the passage 126 gradually increases toward the edge of the corner portion, the bonding process of the touch sensor layer 130 and the polarizing layer 110 is facilitated.

In FIG. 5, the sectional structure of each passage 126 is shown as being triangular, but the present disclosure is not limited thereto. The sectional structure of each passage 126 may be formed in various shapes, such as a semicircular shape and a quadrangular shape.

As described with reference to FIGs. 4 to 6, the transparent adhesive member 120 may include the upper transparent adhesive member 121, the plastic film 122, and the lower transparent adhesive member 123, the plurality of concave portions 124 may be formed at the rear surface of the corner portion of the plastic film 122, and the plurality of passages 126 may be formed at the upper surface of the corner portion of the upper transparent adhesive member 121.

When the touch sensor layer 130 and the polarizing layer 110 are bonded by the transparent adhesive member 120, therefore, bubbles may occur at the corner of the display apparatus, but the bubbles may be discharged to the outside through the plurality of passages 126 formed at the upper surface of the corner portion of the upper transparent adhesive member 121, whereby it is possible to prevent the occurrence of bubbles at the corner of the display apparatus due to bending of the touch sensor layer 130.

In addition, although the adhesive member may protrude to the outside due to the force applied during the bonding process, it is possible to prevent the transparent adhesive member from protruding to the outside due to the fluidity of the transparent adhesive member since the plurality of concave portions 124 is formed at the rear surface of the corner portion of the plastic film 122. In addition, it is possible to improve the corner flatness of the display apparatus.

Hereinafter, a method of manufacturing the display apparatus according to the embodiment of the present disclosure configured as described above will be described.

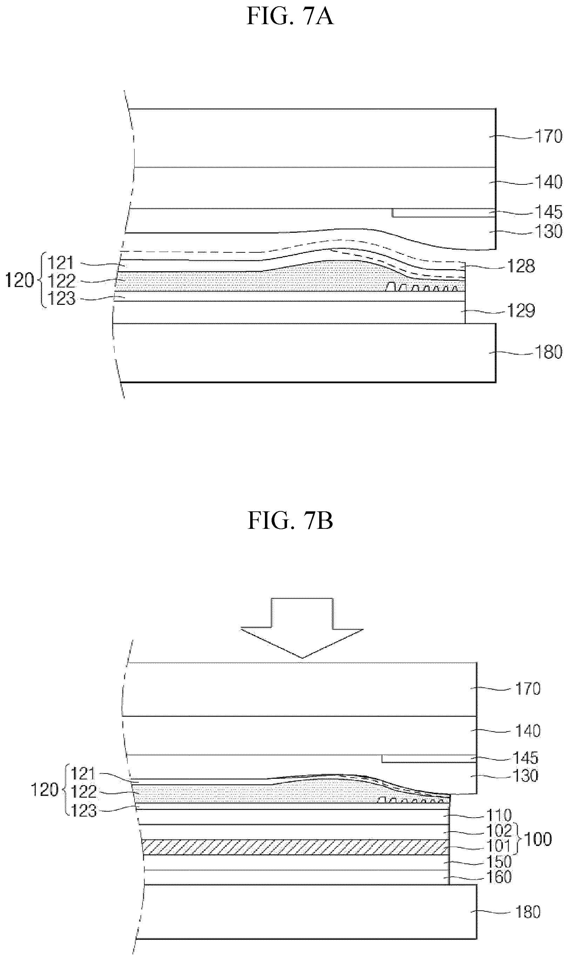

FIGs. 7A to 7D are process sectional views illustrating a method of manufacturing a display apparatus according to an embodiment of the present disclosure.

As shown in FIG. 7A, a cover glass 140 configured such that a black matrix 145 is disposed on a lower surface of the cover glass 140 in a non-active area and a touch sensor layer 130 is disposed under the cover glass 140 is prepared. The cover glass 140 with the black matrix 145 and the touch sensor layer 130 is fixed to a rear surface of an upper chamber 170.

In addition, a transparent adhesive member 120 is prepared.

As described with reference to FIGs. 4 to 6, the transparent adhesive member 120 includes a plastic film 122, an upper transparent adhesive member 121 disposed on an upper surface of the plastic film 122, and a lower transparent adhesive member 123 disposed on a lower surface of the plastic film 122. A plurality of passages 126 is formed at an upper surface of a corner portion of the upper transparent adhesive member 121, and a plurality of concave portions 124 is formed at a rear surface of a corner portion of the plastic film 122.

Here, in order to protect the upper transparent adhesive member 121 and the lower transparent adhesive member 123, a first protective film 128 may be further provided on the upper surface of the upper transparent adhesive member 121, and a second protective film 129 may be further provided on a lower surface of the lower transparent adhesive member 123.

Therefore, the first protective film 128 of the transparent adhesive member 120 is removed, and the transparent adhesive member 120 is located at or fixed to an upper surface of a lower chamber 180. That is, the second protective film 129 of the transparent adhesive member 120 is located or fixed so as to be in contact with the upper surface of the lower chamber 180.

As shown in FIG. 7B, the upper chamber 170 is pressed against the lower chamber 180 to bond the transparent adhesive member 120 to a lower surface of the touch sensor layer 130. Specifically, the upper transparent adhesive member 121 of the transparent adhesive member 120 is bonded to the lower surface of the touch sensor layer 130.

At this time, since the plurality of passages 126 is formed at the upper surface of the corner portion of the upper transparent adhesive member 121, as described with reference to FIG. 5, it is possible to prevent the occurrence of bubbles at the corner of the display apparatus due to bending of the touch sensor layer 130.

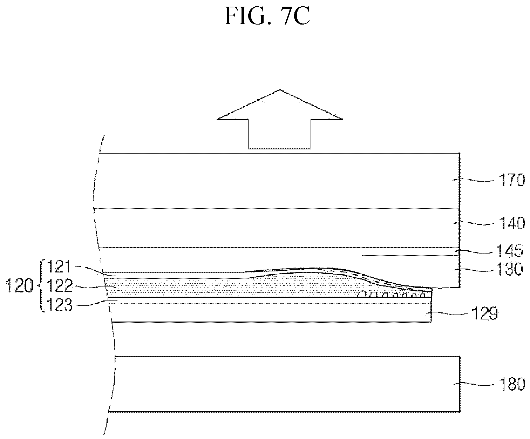

As shown in FIG. 7C, the upper chamber 170 is separated from the lower chamber 180. That is, the upper chamber 170 is moved upward to separate the upper chamber 170 from the lower chamber 180.

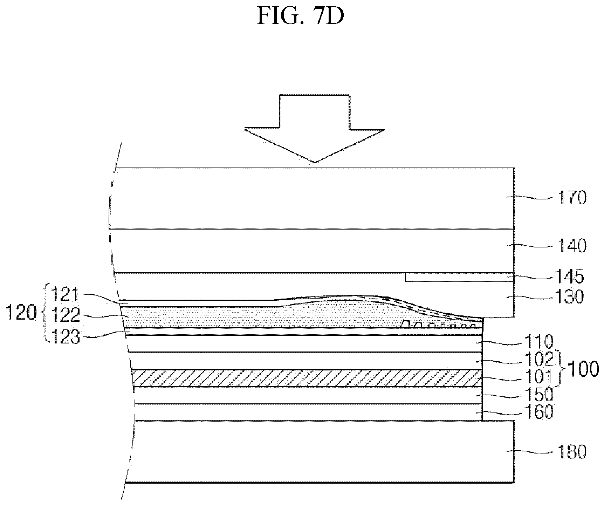

As shown in FIG. 7D, a substrate 101 configured such that an array layer 102 including a thin-film transistor, a light emitting diode, and an encapsulation unit is disposed on the substrate 101, a polarizing layer 110 is disposed on the array layer 102, a back plate 150 is disposed under the substrate 101, and a metal plate 160 is disposed under the back plate 150 is prepared.

The substrate 101 configured as described above is located at or fixed to the upper surface of the lower chamber 180.

The second protective film 129 is removed from the lower surface of the lower transparent adhesive member 123, the upper chamber 170 is pressed against the lower chamber 180 to bond the substrate 101 having the array layer 102, the polarizing layer 110, the back plate 150, and the metal plate 160 disposed thereon to the lower transparent adhesive member 123.

In the bonding process described with reference to FIGs. 7B and 7D, it is possible to prevent the transparent adhesive member 120 from protruding to the outside since the plurality of concave portions 124 each having a trapezoidal structure is provided at the rear surface of the corner portion of the plastic film 122.

In addition, since the plastic film 122 is formed so as to have a thickness that can compensate for bending (step) of the touch sensor layer 130 in consideration of bending of the touch sensor layer 130, it is possible to improve the corner flatness of the display apparatus.

According to the present disclosure as described above, it is possible to reduce the number of defective display apparatuses, thereby reducing product unit cost.

According to the present disclosure, it is possible to realize ESG (Environmental/Social/Governance) goals that can reduce the product unit cost.

A display apparatus according to various embodiments of the present disclosure may be described as follows.

A display apparatus according to at least one embodiment of the present disclosure includes a display panel having an active area and a non-active area, a cover member disposed on the display panel, a touch sensor layer disposed between the display panel and the cover member, and a transparent adhesive member disposed between the display panel and the touch sensor layer, wherein the transparent adhesive member includes a plastic film having a plurality of concave portions provided at a rear surface of a corner portion thereof, an upper transparent adhesive member disposed on an upper surface of the plastic film, and a lower transparent adhesive member disposed on a lower surface of the plastic film.

According to an embodiment of the present disclosure, the plastic film may have a thickness that can compensate for bending of the touch sensor layer in consideration of the bending of the touch sensor layer.

According to an embodiment of the present disclosure, the plastic film may have a convex portion corresponding to a concave portion of the touch sensor layer.

According to an embodiment of the present disclosure, the plurality of concave portions may be disposed in the non-active area, and each may have a depth and width gradually decreasing in a direction toward an edge.

According to an embodiment of the present disclosure, each concave portion may have a trapezoidal structure.

According to an embodiment of the present disclosure, the trapezoidal structure of each concave portion may have a structure perpendicular to a rear surface of the plastic film in a direction toward the edge thereof and an acute-angled structure in the opposite direction.

According to an embodiment of the present disclosure, the upper transparent adhesive member may be provided at an upper surface of a corner portion thereof with a plurality of passages configured to allow bubbles to be discharged to the outside therethrough.

According to an embodiment of the present disclosure, the plurality of passages may be disposed in a fan-shaped manner, each passage may extend in a direction from an area where bubbles are expected to occur to the edge of the corner portion, and the width of each passage may gradually increase in the direction toward the edge of the corner portion.

According to an embodiment of the present disclosure, each passage may have a triangular sectional structure.

According to an embodiment of the present disclosure, the display apparatus may further include a polarizing layer disposed between the display panel and the transparent adhesive member, a back plate disposed on a rear surface of the display panel, and a metal plate disposed on a rear surface of the back plate.

A method of manufacturing a display apparatus according to at least one embodiment of the present disclosure includes preparing a transparent adhesive member including a plastic film having a plurality of concave portions provided at a rear surface of a corner portion thereof, an upper transparent adhesive member disposed on an upper surface of the plastic film, the upper transparent adhesive member being provided at an upper surface of a corner portion thereof with a plurality of passages configured to allow bubbles to be discharged to the outside therethrough, and a lower transparent adhesive member disposed on a lower surface of the plastic film, preparing a cover member and a touch sensor layer disposed under the cover member, bonding the upper transparent adhesive member of the transparent adhesive member to a lower surface of the touch sensor layer, and bonding a display panel having an active area and a non-active area to the lower transparent adhesive member of the transparent adhesive member.

As is apparent from the above description, according to the present disclosure, the transparent adhesive member may include the upper transparent adhesive member, the plastic film, and the lower transparent adhesive member, the plurality of concave portions may be formed at the rear surface of the corner portion of the plastic film, and the plurality of passages may be formed at the upper surface of the corner portion of the upper transparent adhesive member.

When the touch sensor layer and the polarizing layer are bonded by the transparent adhesive member, therefore, bubbles may occur at the corner of the display apparatus, but the bubbles may be discharged to the outside through the plurality of passages formed at the upper surface of the corner portion of the upper transparent adhesive member, whereby it is possible to prevent the occurrence of bubbles at the corner of the display apparatus due to bending of the touch sensor layer.

In addition, since the plurality of concave portions is formed at the rear surface of the corner portion of the plastic film, it is possible to prevent the transparent adhesive member from protruding to the outside due to the fluidity of the transparent adhesive member.

## Claims

1. A display apparatus comprising:
a display panel (100) having an active area and a non-active area;
a cover member (140) disposed on the display panel (100);
a touch sensor layer (130) disposed between the display panel (100) and the cover member (140); and
a transparent adhesive member (120) disposed between the display panel (100) and the touch sensor layer (130), wherein
the transparent adhesive member (120) comprises:
a plastic film (122) having a plurality of concave portions (124) provided at a rear surface of a corner portion thereof;
an upper transparent adhesive member (121) disposed on an upper surface of the plastic film (122); and
a lower transparent adhesive member (123) disposed on a lower surface of the plastic film (122).

2. The display apparatus according to claim 1, wherein the plastic film (122) has a thickness that can compensate for bending of the touch sensor layer (130) in consideration of the bending of the touch sensor layer (130).

3. The display apparatus according to claim 2, wherein the plastic film (122) has a convex portion corresponding to a concave portion of the touch sensor layer (130).

4. The display apparatus according to any of claims 1 to 3, wherein the plurality of concave portions (124) is disposed in the non-active area, and each has a depth and width gradually decreasing in a direction toward an edge.

5. The display apparatus according to any of claims 1 to 4, wherein each concave portion of the plurality of concave portions (124) has a trapezoidal structure.

6. The display apparatus according to claim 5, wherein the trapezoidal structure of each concave portion (124) has a structure perpendicular to a rear surface of the plastic film (122) in a direction toward an edge thereof and an acute-angled structure in an opposite direction.

7. The display apparatus according to any of claims 1 to 6, wherein the upper transparent adhesive member (121) is provided at an upper surface of a corner portion thereof with a plurality of passages (126) configured to allow bubbles to be discharged to an outside therethrough.

8. The display apparatus according to claim 7, wherein the plurality of passages (126) is disposed in a fan-shaped manner, each passage extends in a direction from an area where bubbles are expected to occur to an edge of the corner portion, and a width of each passage (126) gradually increases in the direction toward the edge of the corner portion.

9. The display apparatus according to claim 7 or 8, wherein each passage (126) has a triangular sectional structure.

10. The display apparatus according to any of claims 1 to 9, further comprising:
a polarizing layer (110) disposed between the display panel (100) and the transparent adhesive member (120);
a back plate (150) disposed on a rear surface of the display panel (100); and
a metal plate (160) disposed on a rear surface of the back plate (150).

11. A method of manufacturing a display apparatus, the method comprising:
preparing a transparent adhesive member (120) comprising a plastic film (122) having a plurality of concave portions (124) provided at a rear surface of a corner portion thereof, an upper transparent adhesive member (121) disposed on an upper surface of the plastic film (122), the upper transparent adhesive member (121) being provided at an upper surface of a corner portion thereof with a plurality of passages (126) configured to allow bubbles to be discharged to an outside therethrough, and a lower transparent adhesive member (123) disposed on a lower surface of the plastic film (122);
preparing a cover member (140) and a touch sensor layer (130) disposed under the cover member (140);
bonding the upper transparent adhesive member (121) of the transparent adhesive member (120) to a lower surface of the touch sensor layer (130); and
bonding a display panel (100) having an active area and a non-active area to the lower transparent adhesive member (123) of the transparent adhesive member (120),
the method, preferably, further comprising:
forming a polarizing layer (110) between the display panel (100) and the transparent adhesive member (120);
disposing a back plate (150) on a rear surface of the display panel (100); and
disposing a metal plate (160) on a rear surface of the back plate (150).

12. The method according to claim 11, wherein the plastic film (122) has a thickness that can compensate for bending of the touch sensor layer (130) in consideration of the bending of the touch sensor layer (130),
wherein, preferably, the plastic film (122) has a convex portion corresponding to a concave portion of the touch sensor layer (130).

13. The method according to claim 11 or 12, wherein the plurality of concave portions (124) is disposed in the non-active area, and each has a depth and width gradually decreasing in a direction toward an edge.

14. The method according to any of claims 11 to 13, wherein each concave portion of the plurality of concave portions (124) has a trapezoidal structure,
wherein, preferably, the trapezoidal structure of each concave portion (124) has a structure perpendicular to a rear surface of the plastic film (122) in a direction toward an edge thereof and an acute-angled structure in an opposite direction.

15. The method according to any of claims 11 to 14, wherein the plurality of passages (126) is disposed in a fan-shaped manner, each passage (126) extends in a direction from an area where bubbles are expected to occur to an edge of the corner portion, and a width of each passage (126) gradually increases in the direction toward the edge of the corner portion,
wherein, preferably, each passage (126) has a triangular sectional structure.
